# EUROPEAN PATENT APPLICATION

(11) **EP 3 958 291 A1**
(43) Date of publication of application: **23.02.2022**
(21) Application number: 20192165.7
(22) Date of filing: 21.08.2020
(51) Int. Cl.: H01L 21/027, H01L 21/033

(54) **METHOD FOR FORMING A LIFT-OFF MASK STRUCTURE**

(71) Applicant: AMS AG, 8141 Premstätten (AT)
(72) Inventor: Pertl, Patrik, 5656 AE Eindhoven (NL); Eilmsteiner, Gerhard, 5656 AE Eindhoven (NL)
(74) Representative: OSRAM GmbH - GC IP

(57) **Abstract**

A method for forming a lift-off mask structure (1) comprises providing a substrate body (10), depositing a layer (11) of bottom anti-reflective coating, BARC, over a surface of the substrate body (10), and depositing a layer (12) of photosensitive resist over the BARC layer (11). The method further comprises exposing the resist layer (12) to electromagnetic radiation (21) through a photomask (20), and forming the lift-off mask structure (1) by applying a developer for selectively removing a portion of the BARC layer (11) and of the resist layer (12) such that an underlying portion of the surface of the substrate body (10) is exposed.

## Description

The present disclosure relates to a method for forming a lift-off mask structure. The present disclosure further relates to a device that is manufactured following a process that comprises forming a lift-off mask structure.

In micro- and nanostructuring technology, the lift-off process is a method for creating structures, i.e. patterning, of a target material on a surface of a substrate using a sacrificial material. As an additive technique, lift-off is typically applied in cases where subtracting techniques like etching of structural material would have undesirable effects on subjacent layers. Also, lift-off technique can be performed if there is no appropriate etching method for said material.

The edges of the sacrificial lift-off mask that is formed in the processes first step require a negative sidewall profile, i.e. an undercut profile, to maintain an efficient lift-off procedure. In this way, the remover solution, which dissolves or swells polymers in the mask, after depositing the target material, which is usually a thin metal or dielectric layer, can efficiently get in contact with the substrate mask interface for an efficient lift-off. However, negative sidewall profiles of the lift-off mask result in significant limitations regarding feature dimensions and spacing of the target material. Furthermore, shadowing effects during the deposition of the target material are a common disadvantage in lift-off processes that employ a negative sidewall structure.

It is an object to provide an improved concept of forming a lift-off mask structure for a lift-off process, which overcomes the limitations of present-day solutions.

This object is achieved by the subject-matter of the independent claims. Further developments and embodiments are described in the dependent claims.

The improved concept is based on the idea of forming a lift-off mask structure having positive sidewall profiles in addition to an undercut profile with negative sidewalls at the mask substrate interface. This ensures access for the solvent to the interface after deposition of the target material while also allowing reduced spacing and feature dimensions, hence overcoming the limitations of conventional approaches. The improved concept is realized by a lift-off mask structure that is formed by a light-insensitive bottom antireflective coating, BARC, on a substrate and a layer of resist deposited thereon.

In particular, the method for forming a lift-off mask structure according to the improved concept comprises providing a substrate body, depositing a layer of bottom antireflective coating, BARC, over a surface of the substrate body, and depositing a layer of photosensitive resist over the BARC layer. The method further comprises exposing the resist layer to electromagnetic radiation through a photomask, and forming the lift-off mask structure by applying a developer for selectively removing a portion of the BARC layer and of the resist layer such that an underlying portion of the surface of the substrate body is exposed.

The substrate body is, for example, a semiconductor substrate, such as a silicon wafer or a part of a silicon wafer, or a glass substrate, e.g. a mirror substrate. The substrate body can further comprise functional layers, such as CMOS layers, that are deposited on a substrate.

Onto a surface, e.g. a top surface, of the substrate body, a bilayer structure is formed comprising a developable BARC that is deposited onto the surface of the substrate body, followed by a photosensitive resist that is deposited onto the BARC. Whether a dedicated pre-treatment, e.g. ash or wet clean, of the substrates surface is necessary or not depends on the BARC type and the substrate surface. The substrate surface ideally is in a condition, in which neither an adhesion of the BARC nor lift-off properties are deteriorated. For example, both the resist and the BARC, e.g. a wet-BARC, are deposited via spin coating.

Antireflective coatings are commonly used in conventional photolithography for a reduced reflectivity at the resist-substrate interface during exposure of the resist. With a continual shrinking of pattern geometries down to the nanometer scale, reflection effects such as the formation of standing waves and/or reflective notching can significantly deteriorate the resolution of the lithography process. In addition, a BARC can help to level, or planarize, structures beneath them, creating a smooth surface for the resist layer.

The lift-off mask is eventually formed by selectively removing a portion of the BARC layer and of the resist layer such that an underlying portion of the surface of the substrate body is exposed. For example, the resist is exposed to electromagnetic radiation, e.g. UV light at a wavelength of 365 nm corresponding to the Mercury i-line lithography, which modifies or alters the chemistry of the resist. Depending on the resist type, i.e. positive or negative resist, either exposed or unexposed portions of the resist are subsequently dissolved and removed in a developer solution. Likewise, the BARC is soluble in the developer solution, particularly in an isotropic manner. Therein, the chemistry of the BARC is not influenced or altered by the electromagnetic radiation during the exposure.

The developer solution can be tetra-methyl-ammonium-hydroxide, TMAH, dissolved in an aqueous solution, for instance. Alternative developers are potassium hydroxide, KOH, or sodium metasilicate/phosphate-based developers.

In at least one embodiment, the BARC layer, after forming the lift-off mask structure, is characterized by an undercut profile with negative sidewall slopes.

In at least one embodiment, the resist layer, after forming the lift-off mask structure, is characterized by an overcut profile with positive sidewall slopes.

The different sidewall profiles of the BARC and the positive resist enable minimal shadowing while ensuring ideal lift-off conditions. Firstly, the negative sidewall profile of the BARC layer ensures that the lift-off solvent can easily access the mask-substrate interface, particularly after the target material has been deposited. Secondly, the positive edge profile of the resist enables a significantly reduced shadowing effect during the deposition of the target material, which facilitates greatly reduced feature spacings on the finalized device compared to conventional solutions, in which the entire lift-off mask has a negative sidewall profile.

Photodiode spacing is a common issue when it comes to light-sensing applications exhibiting multiple channels such as CCD spectrometers or imaging sensors. The improved concept featuring different sidewall profiles of the two sublayers of the lift-off photomask enables a much narrower spacing between individual channels/photodiodes, which in turn results in a decreased die size.

For instance, a spacing between two channels of a so-called Fabry-Perot spectrometer sharing the same mirrors can be reduced from ∼28 µm using existing lift-off technology by an order of magnitude to about 3 µm when applying the improved concept. Moreover, the positive sidewalls of the positive resist inhibit the shadowing effect which is often observed during deposition and patterning following conventional approaches.

In at least one embodiment, a material of the BARC layer is not light-sensitive.

In these embodiments, the BARC layer is a non-absorbing coating, for example, which does not change its chemistry due to exposure. As a result, the exposure of the mask can be fully optimized for the photosensitive resist. This is in stark contrast to conventional bi-layer approaches realizing a lift-off mask formed from two photosensitive resist layers. Here, the exposure has to be optimized for both resists, typically leading to inferior lithography results.

In at least one embodiment, a material of the BARC layer is absorbent, in particular highly absorbent, at a wavelength of the electromagnetic radiation.

The lithographic performance of the exposure of the photoresist can be boosted by the BARC, which suppresses unwanted effects such as reflective notching and the formation of standing wave patterns within the resist due to reflection.

In at least one embodiment, a material of the BARC layer is an organic material.

For example, the BARC layer is realized via an organic material such as a polyvinylphenol derivate. Alternatively, the BARC layer can be a single thin layer of a transparent material such as a silica, magnesium fluoride and fluoropolymers, or the BARC layer can comprise alternating layers of a low-index material like silica and a higher-index material. These approaches enable reflectivities as low as 0.1% at a specific wavelength, e.g. the exposure wavelength.

In at least one embodiment, a material of the BARC layer and a material of the photosensitive resist layer are characterized by reflective indices at a wavelength of the electromagnetic radiation that differ by less than 10%, in particular by less than 5%, from each other.

In at least one embodiment, a material of the BARC layer is characterized by a refractive index that causes destructive interference within the resist layer during the exposure to the electromagnetic radiation.

The refractive index of the BARC can be adjusted in such a way that light reflection at the resist-BARC interface and at the BARC-substrate interface, for instance, is cancelled out due to destructive interference. As a result, the approach does not suffer from unwanted lithography effects such as reflective notching or the formation of standing wave patterns particularly within the resist layer. This aspect comes even more into relevance when it comes to patterning of extremely small structures where these artefacts are known to tremendously deteriorate the lithography performance.

In at least one embodiment, depositing the BARC layer comprises depositing a BARC material with a thickness of less than 500 nm, in particular of less than 200 nm, over the surface of the substrate body.

Efficient suppression of unwanted lithography effects can already be achieved with a BARC layer that has a thickness in the order or even smaller than the wavelength of the light used for the exposure of the resist layer. In addition, a thin BARC layer likewise results in a thin lift-off mask, potentially decreasing shadowing effects during deposition of the target material and improving the resolution limit of the lift-off process as a whole.

In at least one embodiment, depositing the photosensitive resist layer comprises depositing a positive photoresist.

For the exposure step, the chemistry of a positive photoresist is changed in such a way, that illuminated areas are dissolvable in the developer solution. Illumination conditions of the exposure can be modified in a manner as to ensure a positive sidewall profile of the positive resist layer, which inhibits shadowing effects during the later deposition step of the target material before the lift-off.

In at least one embodiment, the method according to the improved concept further comprises a step of baking the BARC layer before depositing the resist layer.

Subsequently to coating the surface of the substrate body with the BARC, the latter is temperature treated, e.g. via a baking process, which predefines the edge profile of the lower layer of the lift-off mask after developing. This way, a specific slope profile of BARC layer after developing can be achieved. For example, the BARC layer is temperature treated such that the developing results in a negative sidewall profile at a certain angle.

The positive flank of the resist layer, on the other hand, can be controlled exclusively via the illumination conditions during exposure, while the undercut profile in the BARC layer, as mentioned, is controlled exclusively by the baking of the BARC and the developing recipe. Hence, there is no or minimal cross-influence between both "control parameters" such that an almost independent optimization of the two sidewall profiles can be performed, e.g. in terms of the individual slope angles.

In at least one embodiment, a material of the BARC is soluble in the developer, in particular in an isotropic manner.

If the BARC is removed isotropically by the developer solution that also removes the exposed (or non-exposed) parts of the resist layer, the targeted negative sidewall profile of the BARC layer can be achieved. The exact properties of this undercut can be tailored by adjusting the development recipe and/or development time, for instance.

The aforementioned object is further solved by a device that is manufactured following a process that comprises forming a lift-off mask structure according to one of the embodiments described above.

For example, for manufacturing the device, the method according to one of the embodiments described above is applied repeatedly.

For example, the method according to one of the embodiments described above is applied for manufacturing a multi-layered interference filter, for instance on a surface of a mirror substrate.

Interference filters can be characterized by multiple, e.g. 20 to 100, alternating layers of material. These can each efficiently be manufactured by a lift-off process according to the improved concept.

Further embodiments of the device according to the improved concept become apparent to a person skilled in the art from the embodiments of the method for forming a lift-off mask structure described above.

The following description of figures of exemplary embodiments may further illustrate and explain aspects of the improved concept. Components and parts with the same structure and the same effect, respectively, appear with equivalent reference symbols. Insofar as components and parts correspond to one another in terms of their function in different figures, the description thereof is not necessarily repeated for each of the following figures.

In the figures:
- Figure 1A to 1D: show intermediate products of a lift-off mask according to the improved concept;
- Figure 1E: shows a lift-off mask according to the improved concept;
- Figure 2: shows an intermediate product of a device manufactured following a process that includes a lift-off mask according to the improved concept after deposition of a target material; and
- Figures 3 to 5: show finalized devices manufactured following a process that includes a lift-off mask according to the improved concept after lift-off.

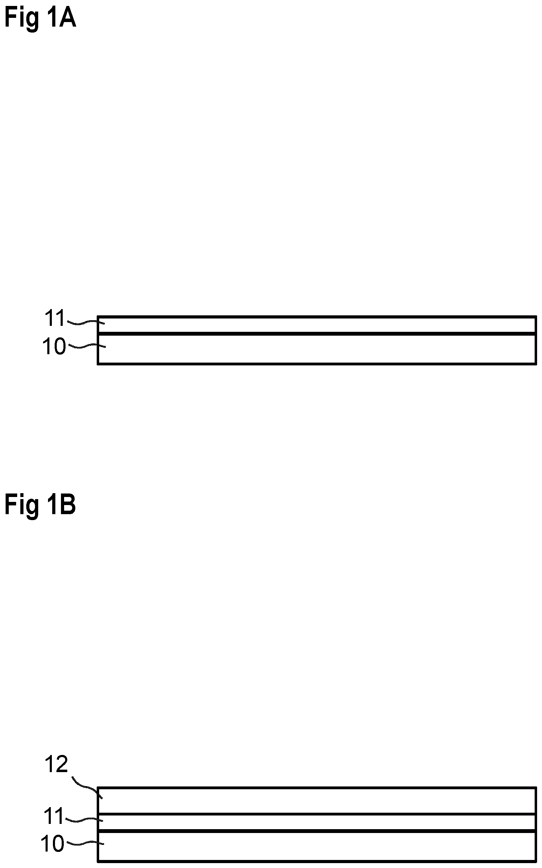

Figure 1A shows an intermediate product of a lift-off mask according to the improved concept after deposition of a bottom anti-reflective coating, BARC, layer 11 over a surface of the substrate body 10.

The substrate body 10 is, for example, a semiconductor substrate, such as a silicon wafer or a part of a silicon wafer, such as a chip. Alternatively, the substrate body 10 is a glass substrate, e.g. a mirror substrate. The substrate body 10 can further comprise functional layers, such as CMOS layers, that are deposited on a substrate.

The BARC layer 11 is deposited onto a top surface of the substrate body 10 as a wet BARC via spin coating, for instance. A thickness of the BARC layer 11 is in the order of 200 nm to 500 nm, for example. The BARC layer 11 is of an organic material, such as a polyvinylphenol derivate. Alternatively, the BARC layer 11 can be a single thin layer of a transparent material such as a silica, magnesium fluoride and fluoropolymers, or the BARC layer 11 can comprise alternating layers of a low-index material like silica and a higher-index material. Optionally, after depositing the BARC layer 11, the intermediate product, in particular the BARC 11, can be temperature treated, for example during a baking process, for adjusting its response to a specific developer recipe. The BARC layer 11 is light-insensitive. This means that its response to a developer is unaffected by light at least at a wavelength used during an exposure, e.g. UV light at a wavelength of 365 nm corresponding to the i-line lithography.

Figure 1B shows the intermediate product of the lift-off mask of Figure 1A after depositing a layer of photosensitive resist 12. The resist layer 12 is a typical positive resist, for example based on a mixture of diazonaphthoquinone, DNQ, and novolac resin, which is a phenol formaldehyde resin. Therein, a positive photoresist is understood as a type of photoresist in which the portion of the photoresist that is exposed to light becomes soluble to the photoresist developer. The unexposed portion of the photoresist remains insoluble to the photoresist developer. The resist layer 12 is deposited via spin coating, for instance with a typical thickness between 450-1500nm.

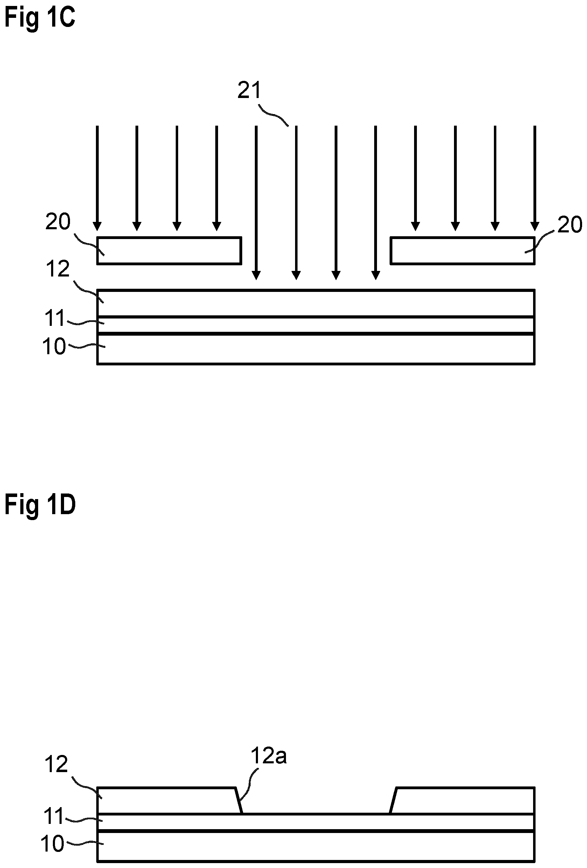

Figure 1C shows the intermediate product of the lift-off mask of Figure 1B during a lithographic exposure step through a photomask 20. Using photolithography, a pattern of the photomask 20 is transferred to the photoresist layer 12. In other words, portions of the resist layer 12 that are covered by opaque portions of the photomask 20 regarding a wavelength of the exposing radiation 21 remain unexposed while portions of the resist layer 12 that are not covered by the opaque portions are exposed to the radiation 21. In the shown example of the resist layer 12 being of a positive resist, the chemistry of the exposed portions of the resist layer 12 is altered by the radiation 21, such that these portions are soluble in a developer solution.

During the exposure, the BARC layer 11 suppresses unwanted lithography effects, such as reflective notching and the formation of standing wave patterns within the resist layer 12, for example via absorption and/or destructive interference. To this end, a refractive index of the BARC layer 11 is adjusted according to a refractive index of the resist layer 12 and/or the substrate body 10. For example, the refractive indices of the aforementioned elements differ from each other by less than 5%.

Alternatively to employing a positive resist as described above, the employment of a negative resist as the resist layer 12 is likewise possible according to the improved concept. For negative resists, the exposed portions remain after the developing while the non-exposed portions are dissolved and thus removed.

Figure 1D shows the intermediate product of the lift-off mask of Figure 1C after a first part of the developing. As described above, previously exposed portions of the positive resist layer 12 are dissolved and thus removed using a developer solution. Therein, a positive sidewall profile 12a, i.e. an overcut profile, can be formed. The slope angle of the positive side walls can be predetermined by parameters of the exposure with the exposing radiation 21. For example, an adjustable focal point of the radiation 21 can be set to a specific depth within the resist layer 12.

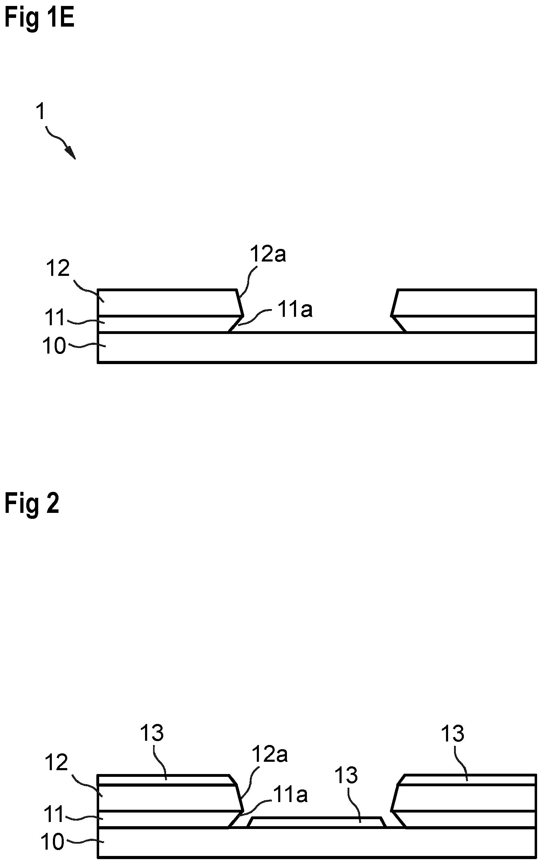

Figure 1E shows a finalized lift-off mask 1 according to the improved concept after a second part of the developing. During the second part, the portion of the BARC layer 11 that is exposed after removing the aforementioned portions of the resist layer 12 is likewise removed by the developer solution used to remove the portions of the resist layer 12. Therein, the BARC layer 11 reacts to the developer solution and an isotropic manner. This way, a negative sidewall profile 11a, i.e. an undercut profile, can be formed. The slope angle of the negative side walls can be predetermined by parameters of the aforementioned temperature treatment of the BARC layer 11 before deposition of the resist layer 12, for instance. For example, the slope angle is in the order of 45°, thus creating an undercut that corresponds to or is in the order of a thickness of the BARC layer 11, for instance in the order of 200 nm.

As can be seen in Figure 1E, the finalized lift-off mask 1 on the substrate body 10 is characterized by a BARC layer 11 with a negative sidewall profile 11a and by a resist layer 12 with a positive sidewall profile 12a. This ensures that a significantly smaller feature spacing, i.e. neighboring openings in the lift-off mask, can be achieved compared to conventional approaches that employ purely negative sidewall profiles of the entire lift-off mask. Furthermore, unwanted liftoff effects such as shadowing are inhibited by the positive sidewall profile 12a of the resist layer 12.

It will be understood that the developer solution can perform the removal of the resist layer 12 and the BARC layer 11 in a simultaneous manner instead of the subsequent manner illustrated in figures 1D and 1E, which mainly serves for illustration purposes.

Figure 2 shows an intermediate product of a device manufactured following a process that includes a lift-off mask according to the improved concept after deposition of a target material 13. For example, the target material 13 is a metal or dielectric. The target material 13 is deposited in a uniform manner on the liftoff mask 1, i.e. remaining portions of the resist layer 12, and in openings created after the developing of the lift-off mask 1. The edges of the structured material 13 are illustrated with a positive sidewall profile. These are typical due to the deposition process not being perfectly anisotropic, resulting in a slight deposition below the roof of the lift-off mask. Perfectly vertical edges of the target material 13 are only achievable via an etching process and not with a lift-off process.

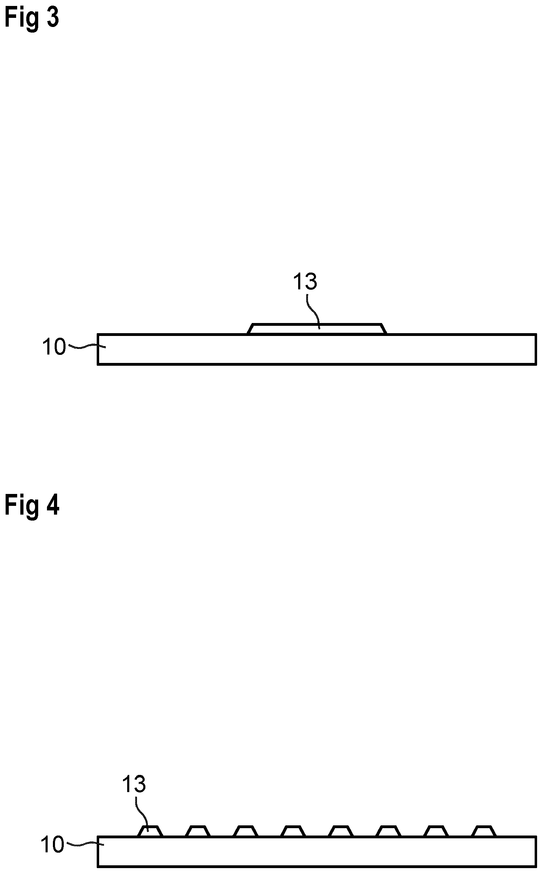

Figure 3 shows the intermediate product of Figure 2 after stripping the lift-off mask 1, i.e. the resist layer 12 and the BARC layer 11, completely from the substrate body 10. Therein, the negative sidewall profile 11a of the BARC layer 11 ensures an unhindered access to the mask-substrate interface for the lift-off solution.

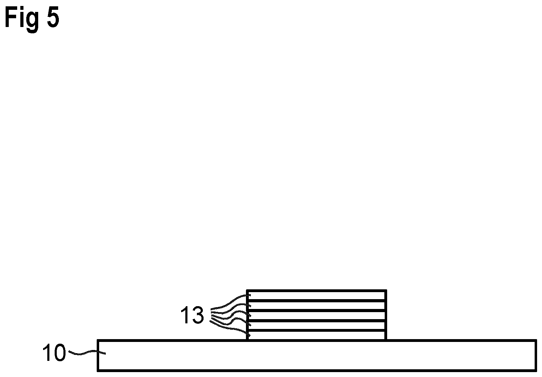

Figures 4 and 5 show further exemplary embodiments of a device manufactured following a process that comprises a lift-off mask according to the improved concept. Figure 4 illustrates that due to the sidewall profiles of the lift-off mask, a significantly smaller feature spacing can be achieved. For example, the target material 13 forms optical elements such as photodiodes of a high-resolution CMOS image sensor.

Figure 5 illustrates how a stack of target materials 13 can be formed via multiple lift-off processes according to the improved concept. Therein, one layer of target material 13 is deposited for each lift-off step. This can be used to form multi-layered optical interference filters on a glass substrate, for instance. Such filters can comprise between 20 and 100 alternating layers of two different target materials 13, for example. For illustration purposes, the sidewall profile of the target material 13 are kept vertical here.

Exact methods to deposit BARC and resist layers and to perform the actual lift-off are well-known concepts and thus are not further detailed in this disclosure.

It is further pointed out that a lift-off mask according to the improved concept is not limited to manufacturing optical devices but can also be used for defining micro- or nano-sized structures of various types, e.g. electrodes of a CMOS circuit.

The embodiments of the lift-off mask and the device manufactured using such a lift-off mask disclosed herein have been discussed for the purpose of familiarizing the reader with novel aspects of the idea. Although preferred embodiments have been shown and described, many changes, modifications, equivalents and substitutions of the disclosed concepts may be made by one having skill in the art without unnecessarily departing from the scope of the claims.

In particular, the disclosure is not limited to the disclosed embodiments, and gives examples of many alternatives as possible for the features included in the embodiments discussed. However, it is intended that any modifications, equivalents and substitutions of the disclosed concepts be included within the scope of the claims which are appended hereto.

Features recited in separate dependent claims may be advantageously combined. Moreover, reference signs used in the claims are not limited to be construed as limiting the scope of the claims.

Furthermore, as used herein, the term "comprising" does not exclude other elements. In addition, as used herein, the article "a" is intended to include one or more than one component or element, and is not limited to be construed as meaning only one.

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is in no way intended that any particular order be inferred.

### Reference numerals

- 1: lift-off mask
- 10: substrate body
- 11: BARC layer
- 12: resist layer
- 11a, 12a: sidewall profile
- 13: target material
- 20: photomask
- 21: exposure radiation

## Claims

1. A method for forming a lift-off mask structure (1), the method comprising:
- providing a substrate body (10);
- depositing a layer (11) of bottom anti-reflective coating, BARC, over a surface of the substrate body (10);
- depositing a layer (12) of photosensitive resist over the BARC layer (11);
- exposing the resist layer (12) to electromagnetic radiation (21) through a photomask (20); and
- forming the lift-off mask structure (1) by applying a developer for selectively removing a portion of the BARC layer (11) and of the resist layer (12) such that an underlying portion of the surface of the substrate body (10) is exposed.

2. The method according to claim 1, wherein the BARC layer (11), after forming the lift-off mask structure (1), is **characterized by** an undercut profile (11a) with negative sidewall slopes.

3. The method according to claim 1 or 2, wherein the resist layer (12), after forming the lift-off mask structure (1), is **characterized by** an overcut profile (12a) with positive sidewall slopes.

4. The method according to one of claims 1 to 3, wherein a material of the BARC layer (11) is not light-sensitive.

5. The method according to one of claims 1 to 4, wherein a material of the BARC layer (11) is absorbent, in particular highly absorbent, at a wavelength of the electromagnetic radiation (21).

6. The method according to one of claims 1 to 5, wherein a material of the BARC layer (11) is an organic material.

7. The method according to one of claims 1 to 6, wherein a material of the BARC layer (11) and a material of the photosensitive resist layer (12) are **characterized by** refractive indices at a wavelength of the electromagnetic radiation (21) that differ by less than 10%, in particular less than 5%, from each other.

8. The method according to one of claims 1 to 7, wherein a material of the BARC layer (11) is **characterized by** a refractive index that causes destructive interference within the resist layer (12) during the exposure to the electromagnetic radiation (21).

9. The method according to one of claims 1 to 8, wherein depositing the BARC layer (11) comprises depositing a BARC material with a thickness of less than 500 nm, in particular less than 200 nm, over the surface of the substrate body (10) .

10. The method according to one of claims 1 to 9, wherein depositing the photosensitive resist layer (12) comprises depositing a positive photoresist.

11. The method according to one of claims 1 to 10, further comprising a step of baking the BARC layer (11) before depositing the resist layer (12).

12. The method according to one of claims 1 to 11, wherein a material of the BARC layer (11) is soluble in the developer, in particular in an isotropic manner.

13. A device that is manufactured following a process that comprises forming a lift-off mask structure (1) according to one of claims 1 to 12.

14. The device according to claim 13, wherein for manufacturing the device, the method according to one of claims 1 to 12 is applied repeatedly.

15. The device according to claim 13 or 14, wherein the method is applied for manufacturing a multi-layered interference filter.
